(19) Europäisches Patentamt / European Patent Office / Office européen des brevets

(11) **EP 4 199 040 A1**

(12) **DEMANDE DE BREVET EUROPEEN**

(43) Date de publication:
**21.06.2023   Bulletin 2023/25**

(21) Numéro de dépôt: **22210688.2**

(22) Date de dépôt: **30.11.2022**

(51) Classification Internationale des Brevets (IPC):
*H01L 21/04* (2006.01)     *H01L 21/18* (2006.01)
*H01L 21/324* (2006.01)     *H01L 21/762* (2006.01)
*H01L 21/02* (2006.01)     *H01L 21/265* (2006.01)

(52) Classification Coopérative des Brevets (CPC):
**H01L 21/187; H01L 21/02002; H01L 21/0405;
H01L 21/76254;** H01L 2021/26573

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité:   **16.12.2021   FR 2113702**

(71) Demandeur: **Commissariat à l'énergie atomique
et aux énergies alternatives
75015 Paris (FR)**

(72) Inventeurs:
• **MASANTE, Cédric**
  **38054 Grenoble cedex 09 (FR)**
• **LE VAN-JODIN, Lucie**
  **38054 Grenoble cedex 09 (FR)**
• **MAZEN, Frédéric**
  **38054 Grenoble cedex 09 (FR)**
• **MILESI, Frédéric**
  **38054 Grenoble cedex 09 (FR)**

(74) Mandataire: **INNOV-GROUP
310, avenue Berthelot
69372 Lyon Cedex 08 (FR)**

(54)   **PROCEDE DE TRANSFERT D'UNE COUCHE UTILE EN DIAMANT CRISTALLIN SUR UN SUBSTRAT SUPPORT**

(57)      Procédé de transfert d'une couche utile (1) sur un substrat support (2), comportant les étapes successives :

a) prévoir un substrat donneur (3) réalisé dans un diamant cristallin ;

b) implanter des espèces gazeuses (4), à travers la première surface (30) du substrat donneur (3), selon une dose et une température données d'implantation adaptées pour former une zone plane graphitique (5) ;

c) assembler le substrat donneur (3) au substrat support (2) par une adhésion directe ;

d) appliquer un recuit thermique selon un budget thermique adapté pour fracturer le substrat donneur (3) suivant la zone plane graphitique (5) ; la température de recuit étant supérieure ou égale à 800°C ;

la température d'implantation est :

supérieure à une température minimale au-delà de laquelle un bullage des espèces gazeuses (4) implantées s'opère à la première surface (30) lorsque le substrat donneur (3) est soumis, en l'absence d'un effet raidisseur, à un recuit thermique selon ledit budget thermique, inférieure à une température maximale au-delà de laquelle la dose donnée d'implantation ne permet plus de former la zone plane graphitique (5).

Figure 1

Fig. 1a — Fig. 1b — Fig. 1c — Fig. 1d — Fig. 1e

## Description

## Domaine technique

L'invention se rapporte au domaine technique du transfert d'une couche utile en diamant cristallin sur un substrat support par la technologie Smart-Cut™.

L'invention trouve notamment son application dans la fabrication de composants de puissance, par exemple des diodes de type Schottky ou des transistors de puissance, ainsi que dans la fabrication de substrats en diamant de grande taille par pavage et reprise d'épitaxie.

## État de l'art

Il est connu de l'état de la technique un procédé de transfert d'une couche utile en matériau monocristallin (notamment en silicium) sur un substrat support, comportant les étapes successives :

$a_{01}$) prévoir un substrat donneur, réalisé dans un matériau monocristallin, et comprenant une première surface ;

$b_{01}$) implanter des espèces gazeuses, comprenant des atomes d'hydrogène ionisé, à travers la première surface du substrat donneur, selon une dose donnée d'implantation adaptée pour former une zone plane endommagée au sein du substrat donneur, la couche utile étant délimitée par la zone plane endommagée et la première surface du substrat donneur ;

$c_{01}$) assembler le substrat donneur au substrat support par une adhésion directe avec la première surface du substrat donneur ;

$d_{01}$) appliquer un recuit thermique à l'assemblage obtenu à l'issue de l'étape $c_{01}$), selon un budget thermique adapté pour fracturer le substrat donneur suivant la zone plane endommagée, de manière à exposer la couche utile.

Il est connu de l'état de la technique, notamment des documents A.A. Gippius et al., « Defect-induced graphitisation in diamond implanted with light ions », Phys. Rev. B Condens. Matter, vol. 308-310, p. 573-576, 2001, R.A. Khmelnitskiy et al., « Blistering in diamond implanted with bydrogen ions », Vacuum, vol. 78, n°2-4, p. 273-279, 2005, G.F. Kuznetsov, « Quantitative analysis of blistering upon annealing of hydrogen-ion-implanted diamond single crystals », Tech. Phys., vol. 51, n°10, p. 1367-1371, 2006, V.P. Popov et al., « Conductive layers in diamond formed by bydrogen ion implantation and annealing », Nuclear Inst. and Methods in Physics Research, B, vol. 282, p. 100-107, 2012, qu'il est possible pour un substrat donneur en diamant ayant subi une étape d'implantation similaire à l'étape $b_{01}$) décrite ci-avant, d'obtenir un bullage des espèces gazeuses implantées à la première surface du substrat donneur lorsque le substrat donneur est soumis, en l'absence d'un effet raidisseur, à un recuit thermique selon un premier budget thermique présentant une température de recuit supérieure à 1300°C. Or, l'obtention d'un bullage satisfaisant en l'absence d'un effet raidisseur permet d'envisager de fracturer le substrat donneur suivant la zone plane endommagée, en présence d'un effet raidisseur (i.e. avec le substrat support collé), en appliquant un recuit thermique selon le premier budget thermique.

Un tel procédé de l'état de la technique n'est pas entièrement satisfaisant dans la mesure où une telle température de recuit (supérieure à 1300°C) est fortement préjudiciable lorsque le substrat donneur et le substrat support, assemblés lors de l'étape $c_{01}$), possèdent des coefficients de dilatation thermique (CTE pour « *Coefficient of Thermal Expansion*» en langue anglaise) significativement différents. En effet, cela peut conduire à la formation de défauts (fissures, « *cracks*» en langue anglaise), voire à une défaillance globale de la structure (casse).

Pour pallier ce problème, il est connu de l'état de la technique un procédé de transfert d'une couche utile en diamant sur un substrat support, comportant les étapes successives :

$a_{02}$) prévoir un substrat donneur, réalisé dans un diamant cristallin, et comprenant une première surface ;

$b_{02}$) implanter des espèces gazeuses, comprenant des atomes d'hydrogène ionisé, à travers la première surface du substrat donneur, selon une dose donnée d'implantation adaptée pour former une zone plane endommagée au sein du substrat donneur, la couche utile étant délimitée par la zone plane endommagée et la première surface du substrat donneur ;

$c_{02}$) appliquer un recuit thermique au substrat donneur, selon un budget thermique possédant une température de recuit comprise entre 800°C et 1000°C, de manière à transformer la zone plane endommagée à l'issue de l'étape $b_{02}$) en une zone plane graphitique ;

$d_{02}$) implanter des espèces gazeuses, comprenant des atomes d'hydrogène ionisé, à travers la première surface du substrat donneur, au niveau de la zone plane graphitique obtenue à l'issue de l'étape $c_{02}$) ;

$e_{02}$) assembler le substrat donneur au substrat support par une adhésion directe avec la première surface du substrat donneur ;

$f_{02}$) appliquer un recuit thermique à l'assemblage obtenu à l'issue de l'étape $e_{02}$), selon un budget thermique adapté pour fracturer le substrat donneur suivant la zone plane graphitique, de manière à exposer la couche utile ; le budget thermique possédant une température de recuit comprise entre 800°C et 1000°C.

Un tel procédé de l'état de la technique n'est pas entièrement satisfaisant dans la mesure où il est nécessaire d'exécuter deux implantations [étape $b_{02}$) et étape $d_{02}$)], ainsi que d'appliquer deux recuits thermiques [étape $c_{02}$) et étape $f_{02}$)], ce qui augmente considérablement le temps d'opération et les coûts associés à la mise en oeuvre de ce procédé. Par ailleurs, un bullage localisé (i.e. s'étendant sur une partie réduite de la première surface du substrat donneur) et non contrôlé des espèces gazeuses implantées lors de l'étape $b_{02}$) est susceptible d'être observé à la première surface du substrat donneur à l'issue de l'étape $c_{02}$). Un tel bullage localisé est fortement préjudiciable quant à la qualité de l'adhésion directe de l'étape $e_{02}$) en raison des exfoliations susceptibles d'apparaître.

L'homme du métier recherche donc une solution pour :

- abaisser la température de recuit de l'étape $d_{01}$),
- exécuter une unique implantation des espèces gazeuses lors de l'étape $b_{01}$).

**Exposé de l'invention**

L'invention vise à remédier en tout ou partie aux inconvénients précités. A cet effet, l'invention a pour objet un procédé de transfert d'une couche utile sur un substrat support, comportant les étapes successives :

a) prévoir un substrat donneur, réalisé dans un diamant cristallin, et comprenant une première surface ;
b) implanter des espèces gazeuses, comprenant des atomes d'hydrogène ionisé, à travers la première surface du substrat donneur, selon une dose donnée d'implantation et une température donnée d'implantation adaptées pour former une zone plane graphitique au sein du substrat donneur, la couche utile étant délimitée par la zone plane graphitique et la première surface du substrat donneur ;
c) assembler le substrat donneur au substrat support par une adhésion directe avec la première surface du substrat donneur ;
d) appliquer un recuit thermique à l'assemblage obtenu à l'issue de l'étape c), selon un budget thermique adapté pour fracturer le substrat donneur suivant la zone plane graphitique, de manière à exposer la couche utile ; le budget thermique présentant une température de recuit supérieure ou égale à 800°C ; procédé dans lequel la température donnée d'implantation, notée T, vérifie :

$T > T_{min}$, où $T_{min}$ est une température minimale au-delà de laquelle un bullage des espèces gazeuses implantées s'opère à la première surface du substrat donneur lorsque le substrat donneur est soumis, en l'absence d'un effet raidisseur, à un recuit thermique selon un budget thermique identique à celui de l'étape d), $T_{min}$ étant

prédéterminée en fonction de la dose donnée d'implantation ; et
$T < T_{max}$, où $T_{max}$ est une température maximale au-delà de laquelle la dose donnée d'implantation ne permet plus de former la zone plane graphitique au sein du substrat donneur.

Ainsi, un tel procédé selon l'invention permet, grâce à l'étape b), d'appliquer un recuit thermique lors de l'étape d) selon un budget thermique présentant une température de recuit pouvant être nettement inférieure à celles de l'état de la technique. Une température de recuit inférieure à celle de l'état de la technique est moins préjudiciable en termes de risque de défaillance de la structure ou de formation de défauts (fissures, « *cracks* » en langue anglaise) lorsque le substrat donneur et le substrat support possèdent des coefficients de dilatation thermique significativement différents.

Contrairement à l'état de la technique, l'étape b) est une implantation unique, à chaud, des espèces gazeuses à travers la première surface du substrat donneur, ce qui permet de réduire la densité de défauts générés.

Les inventeurs ont constaté que l'étape b) doit être exécutée à une température sélectionnée dans une plage de valeurs bornées, afin d'autoriser la fracture du substrat donneur suivant la zone plane graphitique lors de l'étape d).

La température donnée d'implantation à laquelle est exécutée l'étape b) est strictement supérieure à une température minimale ($T_{min}$) au-delà de laquelle un bullage des espèces gazeuses implantées s'opère à la première surface du substrat donneur lorsque le substrat donneur est soumis, en l'absence d'un effet raidisseur, à un recuit thermique selon le budget thermique (modéré par rapport à l'état de la technique) envisagé lors de l'étape d). Le bullage des espèces gazeuses implantées doit s'opérer sur une étendue de la première surface du substrat donneur qui est compatible avec un collage par adhésion directe. $T_{min}$ est déterminée préalablement à la mise en oeuvre d'un procédé selon l'invention. Autrement dit, des expériences préalables peuvent être menées pour déterminer $T_{min}$, consistant à soumettre le substrat donneur, en l'absence d'un effet raidisseur, à un recuit thermique selon un budget thermique identique à celui qui est prévu lors de l'étape d) dans le cadre de la mise en oeuvre d'un procédé selon l'invention.

La température donnée d'implantation à laquelle est exécutée l'étape b) est strictement inférieure à une température maximale ($T_{max}$) au-delà de laquelle la dose donnée d'implantation ne permet plus de former la zone plane graphitique au sein du substrat donneur. En effet, l'augmentation de la température d'implantation engendre une augmentation de la vitesse de recombinaison et/ou de guérison des défauts. Ainsi, lorsque $T \geq T_{max}$, la compétition entre les mécanismes d'endommagement (dans les conditions d'implantation) et les mécanismes de 'guérison' ne conduit pas à la formation d'une couche (zone plane) suffisamment endommagée pour permettre la formation de la zone plane graphitique nécessaire à l'obtention de la fracture.

De telles conditions d'implantation (dose et température) lors de l'étape b) permettent d'obtenir une zone plane graphitique, riche en atomes d'hydrogène, qui pourra conduire à la fracture lors de l'étape d), tout en s'affranchissant d'une double implantation et d'un double recuit thermique de l'état de la technique.

Le procédé selon l'invention peut comporter une ou plusieurs des caractéristiques suivantes.

Selon une caractéristique de l'invention, le budget thermique du recuit thermique appliqué lors de l'étape d) présente une température de recuit comprise entre 800°C et 1200°C, de préférence comprise entre 800°C et 1100°C, plus préférentiellement comprise entre 850°C et 1000°C.

Ainsi, un avantage procuré par un tel budget thermique est de limiter les contraintes mécaniques à l'interface de collage, lorsque le substrat donneur et le substrat support possèdent des coefficients de dilatation thermique significativement différents. Ces contraintes mécaniques peuvent en effet provoquer un détachement prématuré du substrat support avec le substrat donneur avant que le transfert n'ait lieu.

Selon une caractéristique de l'invention, le budget thermique du recuit thermique appliqué lors de l'étape d) présente une durée de recuit comprise entre 30 minutes et 7 heures, de préférence comprise entre 45 minutes et 75 minutes.

Selon une caractéristique de l'invention, la température donnée d'implantation à laquelle est exécutée l'étape b) est strictement supérieure à 250°C, de préférence strictement supérieure à 280°C.

Ainsi, un avantage procuré est d'obtenir un bullage des espèces gazeuses implantées, en l'absence d'un effet raidisseur, s'opérant sur une étendue de la première surface du substrat donneur qui est compatible avec un collage par adhésion directe.

Selon une caractéristique de l'invention, la température donnée d'implantation à laquelle est exécutée l'étape b) est strictement inférieure à 500°C.

Selon une caractéristique de l'invention, la température donnée d'implantation à laquelle est exécutée l'étape b) est strictement inférieure à 400°C, de préférence strictement inférieure à 380°C.

Selon une caractéristique de l'invention, l'étape b) est exécutée de sorte que la dose donnée d'implantation est strictement supérieure à $10^{17}$ at.cm$^{-2}$, de préférence comprise entre $3.10^{17}$ at.cm$^{-2}$ et $4.10^{17}$ at.cm$^{-2}$.

Ainsi, un avantage procuré est d'amorphiser localement le diamant cristallin tout en préservant la qualité cristalline de la couche utile.

Selon une caractéristique de l'invention, les espèces gazeuses sont implantées lors de l'étape b) selon une énergie d'implantation supérieure à 30 keV.

Ainsi, l'énergie d'implantation sera adaptée selon l'épaisseur envisagée de la couche utile.

Selon une caractéristique de l'invention, l'étape b) est l'unique étape d'implantation des espèces gazeuses à travers la première surface du substrat donneur.

Ainsi, un avantage procuré est de limiter le temps d'opération et les coûts associés à la mise en oeuvre du procédé.

Selon une caractéristique de l'invention, le procédé comporte une étape c') consistant à appliquer un recuit thermique à l'assemblage obtenu à l'issue de l'étape c), selon un budget thermique adapté pour renforcer l'interface de collage entre la première surface du substrat donneur et le substrat support sans initier la fracture du substrat donneur suivant la zone plane graphitique ; l'étape c') étant exécutée avant l'étape d), le recuit thermique étant appliqué lors de l'étape d) à l'assemblage obtenu à l'issue de l'étape c').

Ainsi, un avantage procuré est d'augmenter l'énergie d'adhésion de l'interface de collage.

Selon une caractéristique de l'invention, l'étape c) est précédée d'une étape c$_0$) consistant à former une couche superficielle sur la première surface du substrat donneur, l'étape c$_0$) étant exécutée après l'étape b), la couche superficielle étant une couche d'oxyde ou une couche métallique ; le substrat donneur étant assemblé au substrat support lors de l'étape c) par une adhésion directe avec la couche superficielle.

Ainsi, un avantage procuré est d'améliorer la qualité du collage par adhésion directe entre le substrat donneur et le substrat support.

### *Définitions*

- Par « couche utile », on entend une couche à partir de laquelle peut être formé un dispositif pour tout type d'applications, notamment électronique, mécanique, optique etc.
- Par « substrat », on entend un support physique autoporté. Un substrat peut être une tranche (également dénommée plaquette, « *wafer* » en langue anglaise) qui se présente généralement sous la forme d'un disque issu d'une découpe dans un lingot d'un matériau cristallin.
- Par « diamant cristallin », on entend la forme monocristalline ou la forme polycristalline du diamant.
- Par « zone plane », on entend une planéité dans les tolérances usuelles liées aux conditions expérimentales de fabrication, et non une planéité parfaite au sens mathématique du terme.
- Par « graphitique », on entend que la zone plane comporte une phase cristalline de graphite et une phase amorphe de carbone. Le graphite de la phase cristalline peut être nanocristallin. La phase amorphe de carbone est exempte de structures cristallines.
- Par « adhésion directe », on entend un collage spontané issu de la mise en contact direct de deux surfaces, c'est-à-dire en l'absence d'un élément additionnel tel qu'une colle, une cire ou une brasure. L'adhésion provient principalement des forces de van der Waals issues de l'interaction électronique entre les atomes ou les molécules de deux surfaces, des liaisons hydrogène du fait des préparations des surfaces ou des liaisons covalentes établies entre les deux surfaces. On parle également de collage par adhésion moléculaire, ou de collage direct.

- Par « recuit thermique », on entend un traitement thermique comportant :

une phase de montée graduelle en température (rampe de montée) jusqu'à atteindre une température dite température de recuit,
une phase de maintien (plateau) à la température de recuit, pendant une durée dite durée de recuit,
une phase de refroidissement.

- Par « budget thermique », on entend un apport d'énergie de nature thermique, déterminé par le choix d'une valeur de la température de recuit et le choix d'une valeur de la durée du recuit.
- Par « effet raidisseur », on entend l'effet provoqué (en termes de rigidité conférée) par la présence d'un substrat support assemblé au substrat donneur, permettant le transfert de la couche utile sans apparition de cloquage.
- Par « prédéterminée », on entend que $T_{min}$ est déterminée préalablement à la mise en oeuvre d'un procédé selon l'invention. Des expériences préalables peuvent être menées pour déterminer $T_{min}$, ces expériences consistant à soumettre le substrat donneur, en l'absence d'un effet raidisseur, à un recuit thermique selon un budget thermique identique à celui qui est prévu lors de l'étape d) dans le cadre de la mise en oeuvre d'un procédé selon l'invention.
- Par « s'opère à la première surface », on entend que le bullage des espèces gazeuses implantées s'opère, en l'absence d'effet raidisseur, sur une étendue de la première surface du substrat donneur qui est compatible avec un collage par adhésion directe.
- Les valeurs X et Y exprimées à l'aide des expressions « entre X et Y » ou « compris entre X et Y » sont incluses dans la plage de valeurs définie.
- « at. » désigne le terme « atomes ».
- Par « couche superficielle », on entend une couche recouvrant la première surface du substrat donneur.

**Brève description des dessins**

D'autres caractéristiques et avantages apparaîtront dans l'exposé détaillé de différents modes de réalisation de l'invention, l'exposé étant assorti d'exemples et de références aux dessins joints.

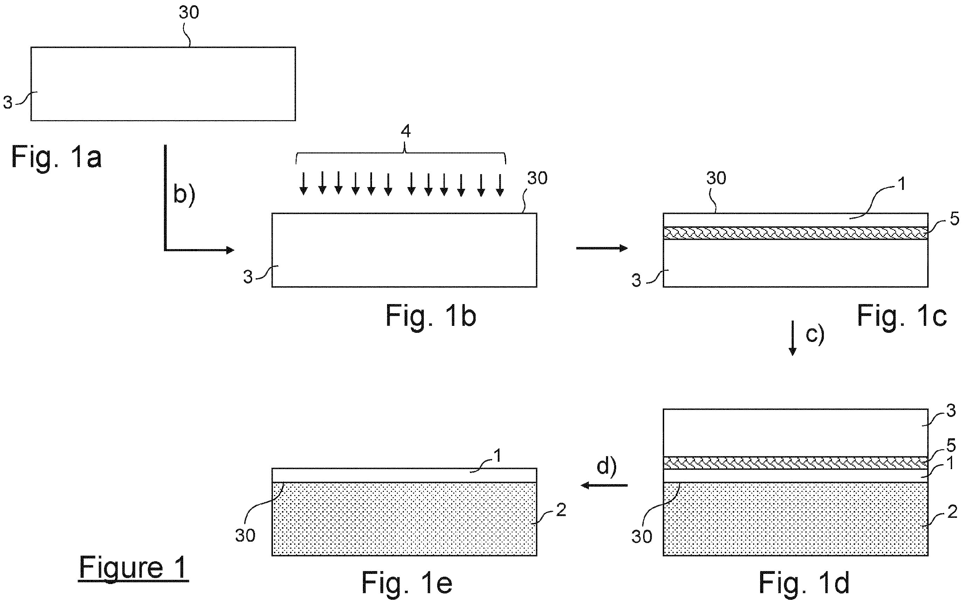

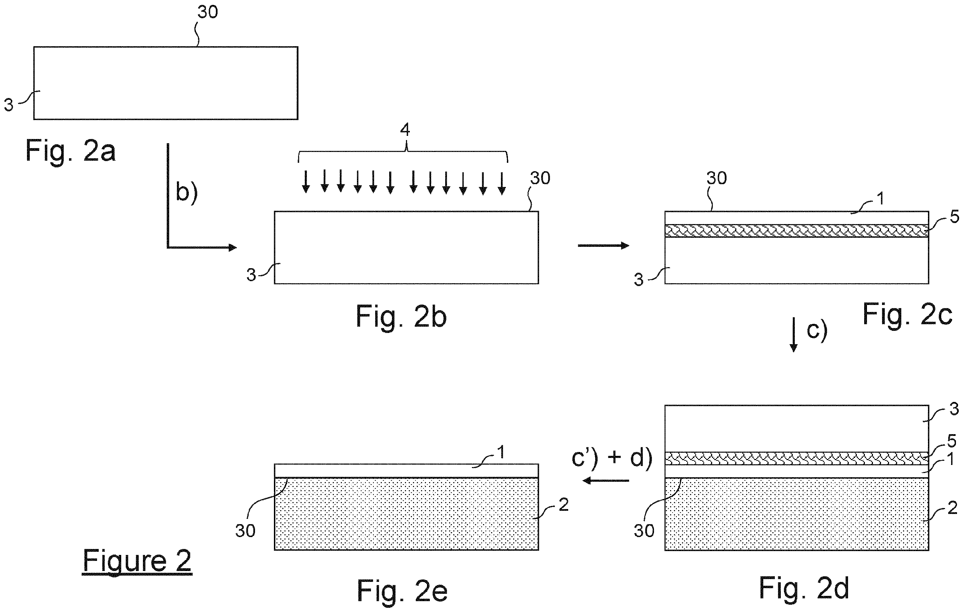

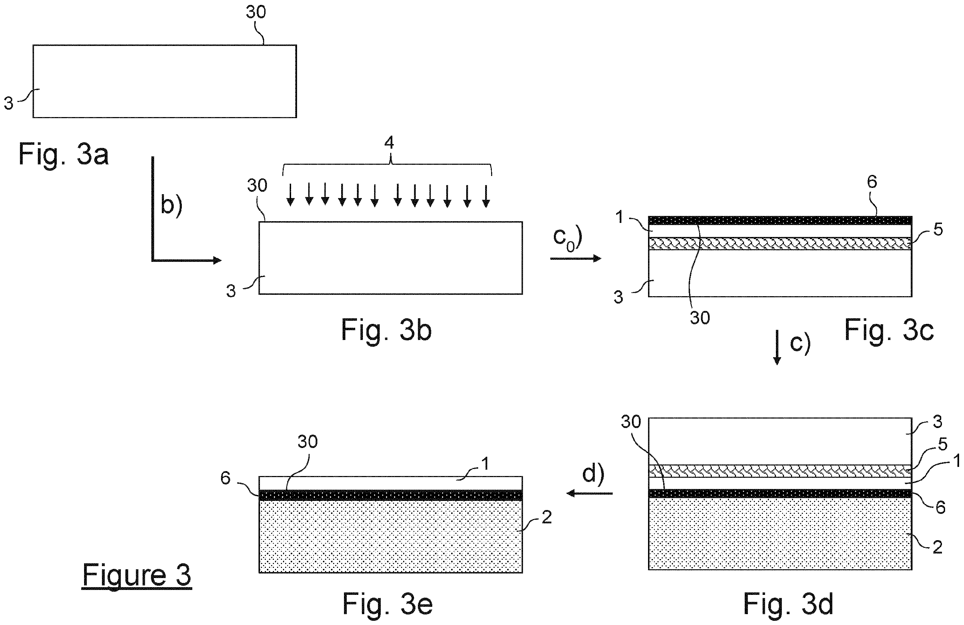

Figure 1 (1a à 1e) comporte des vues schématiques en coupe illustrant des étapes d'un premier mode de mise en oeuvre d'un procédé selon l'invention. Figure 2 (2a à 2e) comporte des vues schématiques en coupe illustrant des étapes d'un deuxième mode de mise en oeuvre d'un procédé selon l'invention. Figure 3 (3a à 3e) comporte des vues schématiques en coupe illustrant des étapes d'un troisième mode de mise en oeuvre d'un procédé selon l'invention.

Il est à noter que les dessins décrits ci-avant sont schématiques, et ne sont pas nécessairement à l'échelle par souci de lisibilité et pour en simplifier leur compréhension. Les coupes sont effectuées selon la normale à la première surface du substrat donneur.

**Exposé détaillé des modes de réalisation**

Les éléments identiques ou assurant la même fonction porteront les mêmes références pour les différents modes de réalisation, par souci de simplification.

Comme illustré aux figures 1 à 3, un objet de l'invention est un procédé de transfert d'une couche utile 1 sur un substrat support 2, comportant les étapes successives :

a) prévoir un substrat donneur 3, réalisé dans un diamant cristallin, et comprenant une première surface 30 ;
b) implanter des espèces gazeuses 4, comprenant des atomes d'hydrogène ionisé, à travers la première surface 30 du substrat donneur 3, selon une dose donnée d'implantation et une température donnée d'implantation adaptées pour former une zone plane graphitique 5 au sein du substrat donneur 3, la couche utile 1 étant délimitée par la zone plane graphitique 5 et la première surface 30 du substrat donneur 3 ;
c) assembler le substrat donneur 3 au substrat support 2 par une adhésion directe avec la première surface 30 du substrat donneur 3 ;
d) appliquer un recuit thermique à l'assemblage obtenu à l'issue de l'étape c), selon un budget thermique adapté pour fracturer le substrat donneur 3 suivant la zone plane graphitique 5, de manière à exposer la couche utile 1.

Le budget thermique du recuit thermique appliqué lors de l'étape d) présente une température de recuit supérieure ou égale à 800°C.

L'étape b) est exécutée à la température donnée d'implantation, notée T, vérifiant :

$T > T_{min}$, où $T_{min}$ est une température minimale au-delà de laquelle un bullage des espèces gazeuses 4 implantées s'opère à la première surface 30 du substrat donneur 3 lorsque le substrat donneur 3 est soumis, en l'absence d'un effet raidisseur, à un recuit thermique selon un budget thermique identique à celui de l'étape d), $T_{min}$ étant prédéterminée en fonction de la dose donnée d'implantation ; et

$T < T_{max}$, où $T_{max}$ est une température maximale audelà de laquelle la dose donnée d'implantation ne permet plus de former la zone plane graphitique 5 au sein du substrat donneur 3.

### Etape a)

L'étape a) est illustrée aux figures la, 2a, 3a.
La première surface 30 du substrat donneur 3 peut présenter une superficie de l'ordre de quelques millimètres carrés. La première surface 30 du substrat donneur 3 peut être orientée en termes de plans cristallins selon les indices de Miller [100]. À titre d'exemple non limitatif, le substrat donneur 3 peut présenter une épaisseur de l'ordre de 0,5 mm.

### Etape b)

L'étape b) est illustrée aux figures 1b et 1c, 2b et 2c, 3b et 3c.
L'étape b) est l'unique étape d'implantation des espèces gazeuses 4 à travers la première surface 30 du substrat donneur 3. En d'autres termes, le procédé selon l'invention comporte une unique étape d'implantation des espèces gazeuses 4 à travers la première surface 30 du substrat donneur 3. Le procédé selon l'invention est avantageusement dépourvu d'une étape d'implantation d'espèces non-gazeuses, avant l'étape c), dans une zone du substrat donneur 3 correspondant à la zone plane graphitique 5.
Les espèces gazeuses 4 peuvent comporter des atomes d'hélium ionisé, en addition des atomes d'hydrogène ionisé. En d'autres termes, les atomes d'hydrogène ionisés et les atomes d'hélium ionisés peuvent être co-implantés lors de l'étape b).
La température donnée d'implantation à laquelle est exécutée l'étape b) est avantageusement strictement supérieure à 250°C, de préférence strictement supérieure à 280°C. En d'autres termes, $T_{min}$ est comprise entre 250°C et de 280°C.
La température donnée d'implantation à laquelle est exécutée l'étape b) est préférentiellement strictement inférieure à 500°C. La température donnée d'implantation à laquelle est exécutée l'étape b) est avantageusement strictement inférieure à 400°C, de préférence strictement inférieure à 380°C. En d'autres termes, $T_{max}$ est comprise entre 380°C et 500°C, avantageusement comprise entre 380°C et 400°C.
L'étape b) est avantageusement exécutée de sorte que la dose donnée d'implantation est strictement supérieure à $10^{17}$ at.cm$^{-2}$, de préférence comprise entre $3.10^{17}$ at.cm$^{-2}$ et $4.10^{17}$ at.cm$^{-2}$.
Les espèces gazeuses 4 sont avantageusement implantées lors de l'étape b) selon une énergie d'implantation supérieure à 30 keV. L'étape b) peut être exécutée de sorte que la couche utile 1 présente une épaisseur comprise entre quelques dizaines de nanomètres et quelques microns. Par « épaisseur », on entend une dimension s'étendant selon la normale à la première surface 30 du substrat donneur 3.
L'étape b) est avantageusement exécutée de sorte que la zone plane graphitique 5 s'étend sur toute la superficie de la première surface 30 du substrat donneur 3, à une profondeur donnée de la première surface 30. La profondeur de la zone plane graphitique 5 (à partir de la première surface 30 du substrat donneur 3) est principalement déterminée par l'énergie d'implantation.

### Etape c)

L'étape c) est illustrée aux figures 1d, 2d et 3d.
L'étape c) peut être précédée d'étapes consistant à nettoyer ou préparer la première surface 30 du substrat donneur 3 (plus généralement la surface à coller), par exemple pour éviter la contamination de la première surface 30 par des hydrocarbures, des particules ou des éléments métalliques. À titre d'exemple non limitatif, il est possible de traiter la première surface 30 à l'aide d'une solution diluée SC1 (mélange de $NH_4OH$ et de $H_2O_2$) afin de provoquer des liaisons chimiques de surface aptes à réaliser une bonne adhésion.
Comme illustré à la figure 3c, l'étape c) peut être précédée d'une étape $c_0$) consistant à former une couche superficielle 6 sur la première surface 30 du substrat donneur 3. L'étape $c_0$) est exécutée après l'étape b). La couche superficielle 6 est avantageusement une couche d'oxyde ou une couche métallique. La couche superficielle 6 a pour rôle de faciliter le collage subséquent. La couche d'oxyde peut être réalisée en $SiO_2$. La couche métallique peut être réalisée dans un matériau métallique choisi parmi Ti, W. La couche superficielle 6 peut présenter une épaisseur comprise entre quelques nanomètres et 1 $\mu$m.
L'étape c) est exécutée à une température et à une pression adaptées selon le type de collage mis en oeuvre.
En cas de présence d'une couche superficielle 6 revêtant la première surface 30 du substrat donneur 3, le substrat donneur 3 est assemblé au substrat support 2 lors de l'étape c) par une adhésion directe avec la couche superficielle 6.
Dans le mode de mise en oeuvre illustré à la figure 2, le procédé comporte avantageusement une étape c') consistant à appliquer un recuit thermique à l'assemblage obtenu à l'issue de l'étape c), selon un budget thermique adapté pour renforcer l'interface de collage entre la première surface 30 du substrat donneur 3 et le substrat support 2 sans initier la fracture du substrat donneur 3 suivant la zone plane graphitique 5. L'étape c') est exécutée avant l'étape d). Le budget thermique pour renforcer l'interface de collage est avantageusement inférieur à 10% du budget thermique de fracture, c'est-àdire le budget thermique appliqué lors de l'étape d). Il est possible de définir un pourcentage du budget thermique de fracture. Le budget thermique de fracture peut être décrit par une loi de type Arrhenius permettant de relier le temps de la fracture (noté « t ») à la température de recuit (notée « $T_r$ », en kelvins) :

$$t = A \, exp \left( {-E_a}/{kT_r} \right)$$

où :

- « A » est une constante,
- « $E_a$ » est une constante correspondant à l'énergie d'activation du mécanisme impliqué dans la fracture,
- « k » est la constante de Boltzmann.

« $E_a$ » peut être déterminée expérimentalement à partir de deux points de fonctionnement : il s'agit de la pente de la droite « log(t) » en fonction de « $1/kT_r$ ».

« $E_a$ » étant connue, on détermine facilement pour une température de recuit « $T_{r1}$ » donnée, le temps « $t_1$ » nécessaire à l'obtention de la fracture. Par convention, on dira que le pourcentage du budget thermique utilisé correspond au pourcentage du temps « $t_1$ » passé à la température « $T_{r1}$ ». Ainsi, par exemple, pour rester à moins de 10% du budget thermique de fracture, on choisira une durée « t » inférieure à « $t_1/10$ » pour un recuit thermique à une température de recuit « $T_{r1}$ ».

Le procédé selon l'invention est avantageusement dépourvu d'une étape de traitement thermique du substrat donneur 3 obtenu à l'issue de l'étape b), exécutée avant l'étape c) d'assemblage au substrat support 2. En d'autres termes, le procédé selon l'invention est avantageusement dépourvu d'une étape de traitement thermique exécutée entre l'étape b) et l'étape c).

À titre d'exemple non limitatif, le substrat support 2 peut être réalisé dans un matériau choisi parmi Si, SiC, GaN, un diamant polycristallin.

*Etape d)*

L'étape d) est illustrée aux figures 1e, 2e et 3e.

Le budget thermique du recuit thermique appliqué lors de l'étape d) présente avantageusement une température de recuit comprise entre 800°C et 1200°C, de préférence comprise entre 800°C et 1100°C, plus préférentiellement comprise entre 850°C et 1000°C.

Le budget thermique du recuit thermique appliqué lors de l'étape d) présente avantageusement une durée de recuit comprise entre 30 minutes et 7 heures, de préférence comprise entre 45 minutes et 75 minutes.

En cas d'exécution de l'étape c'), le recuit thermique est appliqué lors de l'étape d) à l'assemblage obtenu à l'issue de l'étape c').

L'étape d) est avantageusement exécutée dans un milieu à atmosphère contrôlée afin de limiter la présence d'oxygène qui consomme le diamant cristallin par formation d'oxydes (CO, $CO_2$). À titre d'exemple non limitatif, l'étape d) peut être exécutée sous un vide poussé tel qu'un vide secondaire inférieur à $10^5$ mbar ou sous une atmosphère neutre (e.g. argon).

*Exemple de réalisation*

La première surface 30 du substrat donneur 3, prévu lors de l'étape a), en diamant monocristallin, est orientée en termes de plans cristallins selon les indices de Miller [100]. Le substrat donneur 3 présente une épaisseur de 0,5 mm. La première surface 30 du substrat donneur 3 présente une superficie de $4 \times 4$ mm$^2$.

L'étape b) est exécutée selon les conditions suivantes :

- la dose donnée d'implantation est égale à $3,7.10^{17}$ cm$^{-2}$ ;
- l'énergie d'implantation est égale à 150 keV ;
- la température d'implantation est égale à 283°C.

La zone plane graphitique 5 formée à l'issue de l'étape b) présente une épaisseur de l'ordre de 100 nm, et est située à une profondeur de la première surface 30 de l'ordre de 800 nm.

L'étape d) est exécutée à une température de recuit de 1000°C pendant une durée de 60 minutes.

L'invention ne se limite pas aux modes de réalisation exposés. L'homme du métier est mis à même de considérer leurs combinaisons techniquement opérantes, et de leur substituer des équivalents.

**Revendications**

1.  Procédé de transfert d'une couche utile (1) sur un substrat support (2), comportant les étapes successives :

    a) prévoir un substrat donneur (3), réalisé dans un diamant cristallin, et comprenant une première surface (30) ;
    b) implanter des espèces gazeuses (4), comprenant des atomes d'hydrogène ionisé, à travers la première surface (30) du substrat donneur (3), selon une dose donnée d'implantation et une température donnée d'implantation adaptées pour former une zone plane graphitique (5) au sein du substrat donneur (3), la couche utile (1) étant délimitée par la zone plane graphitique (5) et la première surface (30) du substrat donneur (3) ;
    c) assembler le substrat donneur (3) au substrat support (2) par une adhésion directe avec la première surface (30) du substrat donneur (3) ;
    d) appliquer un recuit thermique à l'assemblage obtenu à l'issue de l'étape c), selon un budget thermique adapté pour fracturer le substrat donneur (3) suivant la zone plane graphitique (5),

de manière à exposer la couche utile (1) ; le budget thermique présentant une température de recuit supérieure ou égale à 800°C ;

procédé dans lequel la température donnée d'implantation, notée T, vérifie :

$T > T_{min}$, où $T_{min}$ est une température minimale au-delà de laquelle un bullage des espèces gazeuses (4) implantées s'opère à la première surface (30) du substrat donneur (3) lorsque le substrat donneur (3) est soumis, en l'absence d'un effet raidisseur, à un recuit thermique selon un budget thermique identique à celui de l'étape d), $T_{min}$ étant prédéterminée en fonction de la dose donnée d'implantation, la température donnée d'implantation à laquelle est exécutée l'étape b) étant strictement supérieure à 250°C, de préférence strictement supérieure à 280°C ; et

$T < T_{max}$, où $T_{max}$ est une température maximale au-delà de laquelle la dose donnée d'implantation ne permet plus de former la zone plane graphitique (5) au sein du substrat donneur (3).

2. Procédé selon la revendication 1, dans lequel le budget thermique du recuit thermique appliqué lors de l'étape d) présente une température de recuit comprise entre 800°C et 1200°C, de préférence comprise entre 800°C et 1100°C, plus préférentiellement comprise entre 850°C et 1000°C.

3. Procédé selon la revendication 1 ou 2, dans lequel le budget thermique du recuit thermique appliqué lors de l'étape d) présente une durée de recuit comprise entre 30 minutes et 7 heures, de préférence comprise entre 45 minutes et 75 minutes.

4. Procédé selon l'une des revendications 1 à 3, dans lequel la température donnée d'implantation à laquelle est exécutée l'étape b) est strictement inférieure à 500°C.

5. Procédé selon l'une des revendications 1 à 4, dans lequel la température donnée d'implantation à laquelle est exécutée l'étape b) est strictement inférieure à 400°C, de préférence strictement inférieure à 380°C.

6. Procédé selon l'une des revendications 1 à 5, dans lequel l'étape b) est exécutée de sorte que la dose donnée d'implantation est strictement supérieure à $10^{17}$ at.cm$^{-2}$, de préférence comprise entre $3.10^{17}$ at.cm$^{-2}$ et $4.10^{17}$ at.cm$^{-2}$.

7. Procédé selon l'une des revendications 1 à 6, dans lequel les espèces gazeuses (4) sont implantées lors de l'étape b) selon une énergie d'implantation supérieure à 30 keV.

8. Procédé selon l'une des revendications 1 à 7, dans lequel l'étape b) est l'unique étape d'implantation des espèces gazeuses (4) à travers la première surface (30) du substrat donneur (3).

9. Procédé selon l'une des revendications 1 à 8, comportant une étape c') consistant à appliquer un recuit thermique à l'assemblage obtenu à l'issue de l'étape c), selon un budget thermique adapté pour renforcer l'interface de collage entre la première surface (30) du substrat donneur (3) et le substrat support (2) sans initier la fracture du substrat donneur (3) suivant la zone plane graphitique (5) ;

l'étape c') étant exécutée avant l'étape d), le recuit thermique étant appliqué lors de l'étape d) à l'assemblage obtenu à l'issue de l'étape c').

10. Procédé selon l'une des revendications 1 à 9, dans lequel l'étape c) est précédée d'une étape $c_0$) consistant à former une couche superficielle (6) sur la première surface (30) du substrat donneur (3), l'étape $c_0$) étant exécutée après l'étape b), la couche superficielle (6) étant une couche d'oxyde ou une couche métallique ; le substrat donneur (3) étant assemblé au substrat support (2) lors de l'étape c) par une adhésion directe avec la couche superficielle (6).

Fig. 1a

b)

Fig. 1b

Fig. 1c

c)

Fig. 1d

d)

Fig. 1e

Figure 1

EP 4 199 040 A1

Fig. 2a

Fig. 2b

Fig. 2c

Fig. 2d

Fig. 2e

Figure 2

Fig. 3a

Fig. 3b

Fig. 3c

Fig. 3d

Fig. 3e

Figure 3

Europäisches
Patentamt

European
Patent Office

Office européen
des brevets

**RAPPORT DE RECHERCHE EUROPEENNE**

Numéro de la demande

EP 22 21 0688

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 6 150 239 A (GOESELE ULRICH M [US] ET AL) 21 novembre 2000 (2000-11-21) * colonne 6, lignes 29-34; revendications 21, 25 * ----- | 1-10 | INV. H01L21/04 H01L21/18 H01L21/324 H01L21/762 |
| A | US 2005/181210 A1 (DOERING PATRICK J [US] ET AL) 18 août 2005 (2005-08-18) * revendication 1; tableau 1 * ----- | 1-10 | H01L21/02 ADD. H01L21/265 |
| A | PIÑERO J C ET AL: "Lattice performance during initial steps of the Smart-Cut(TM) process in semiconducting diamond: A STEM study", APPLIED SURFACE SCIENCE, ELSEVIER, AMSTERDAM, NL, vol. 528, 19 juin 2020 (2020-06-19), XP086262440, ISSN: 0169-4332, DOI: 10.1016/J.APSUSC.2020.146998 [extrait le 2020-06-19] * alinéa [0004]; figure 1; tableau 1 * ----- | 1-10 | |
| A,D | KHMELNITSKIY R A ET AL: "Blistering in diamond implanted with hydrogen ions", VACUUM, PERGAMON PRESS, GB, vol. 78, no. 2-4, 30 mai 2005 (2005-05-30), pages 273-279, XP027613023, ISSN: 0042-207X [extrait le 2005-05-30] * abrégé * ----- -/-- | 1-10 | DOMAINES TECHNIQUES RECHERCHES (IPC) H01L |

Le présent rapport a été établi pour toutes les revendications

| Lieu de la recherche | Date d'achèvement de la recherche | Examinateur |
|---|---|---|
| La Haye | 11 avril 2023 | Ott, André |

EPO FORM 1503 03.82 (P04C02)

page 1 de 2

**Europäisches Patentamt**
**European Patent Office**
**Office européen des brevets**

# RAPPORT DE RECHERCHE EUROPEENNE

Numéro de la demande

EP 22 21 0688

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | "Layer splitting process in hydrogen-implanted Si, Ge, SiC, and diamond substrates", APPLIED PHYSICS LETTERS, AMERICAN INSTITUTE OF PHYSICS, 2 HUNTINGTON QUADRANGLE, MELVILLE, NY 11747, vol. 70, no. 11, 17 mars 1997 (1997-03-17), pages 1390-1392, XP012017424, ISSN: 0003-6951, DOI: 10.1063/1.118586 * colonne 4, alinéa 3 * ----- | 4,5 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| La Haye | 11 avril 2023 | Ott, André |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

page 2 de 2

## ANNEXE AU RAPPORT DE RECHERCHE EUROPEENNE
## RELATIF A LA DEMANDE DE BREVET EUROPEEN NO.

EP 22 21 0688

11-04-2023

| Document brevet cité au rapport de recherche | | Date de publication | Membre(s) de la famille de brevet(s) | | Date de publication |
|---|---|---|---|---|---|
| US 6150239 | A | 21-11-2000 | EP | 1118108 A1 | 25-07-2001 |
| | | | JP | 2003524876 A | 19-08-2003 |
| | | | JP | 2010219566 A | 30-09-2010 |
| | | | KR | 20010079959 A | 22-08-2001 |
| | | | US | 6150239 A | 21-11-2000 |
| | | | WO | 0019499 A1 | 06-04-2000 |
| US 2005181210 | A1 | 18-08-2005 | US | 2005181210 A1 | 18-08-2005 |
| | | | WO | 2005080645 A2 | 01-09-2005 |

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **A.A. GIPPIUS et al.** Defect-inducedgraphitisation in diamond implanted with light ions. *Phys. Rev. B Condens. Matter,* 2001, vol. 308-310, 573-576
- **R.A. KHMELNITSKIY et al.** Blistering in diamond implanted with bydrogen ions. *Vacuum,* 2005, vol. 78 (2-4), 273-279
- **G.F. KUZNETSOV.** Quantitative analysis of blistering upon annealing of hydrogen-ion-implanted diamond single crystals. *Tech. Phys.,* 2006, vol. 51 (10), 1367-1371
- **V.P. POPOV et al.** Conductive layers in diamond formed by bydrogen ion implantation and annealing. *Nuclear Inst. and Methods in Physics Research, B,* 2012, vol. 282, 100-107